# EUROPEAN PATENT APPLICATION

(11) **EP 4 509 847 A1**
(43) Date of publication of application: **19.02.2025**
(21) Application number: 23191722.0
(22) Date of filing: 16.08.2023
(51) Int. Cl.: G01R 31/12, H02H 1/00

(54) **ARCING AND IONIZATION DETECTION IN AUTOMOTIVE BATTERIES BY USING FREQUENCY SPECTRUM**

(71) Applicant: Samsung SDI Co., Ltd., Yongin-si, Gyeonggi-do 17084 (KR)
(72) Inventor: Maxl, Florian, 8020 Graz (AT); Ipek, Eymen, 8020 Graz (AT)
(74) Representative: Gulde & Partner

(57) **Abstract**

The present disclosure refers to a method for detecting the occurrence of a dielectric breakdown in a battery module. The present disclosure further refers to a method for disconnecting a battery module from a load upon detection of a dielectric breakdown in a battery module. Also, the present invention is related to a battery system with a battery module, the battery system being configured for performing the disclosed method for detecting the occurrence of a dielectric breakdown in a battery module and/or being configured for performing the disclosed method for disconnecting a battery module from a load upon detection of a dielectric breakdown in a battery module. Also, the present disclosure is related to a vehicle comprising at least one battery system according to the disclosure.

## Description

### Field of the Disclosure

The present disclosure relates to a method for detecting the occurrence of a dielectric breakdown in a battery module. The present disclosure further relates to a method for disconnecting a battery module from a load upon detection of a dielectric breakdown in a battery module. Also, the present invention is related to a battery system with a battery module, the battery system being configured for performing the disclosed method for detecting the occurrence of a dielectric breakdown in a battery module and/or being configured for performing the disclosed method for disconnecting a battery module from a load upon detection of a dielectric breakdown in a battery module. Also, the present disclosure is related to a vehicle comprising at least one battery system according to the disclosure.

### Technological Background

In the recent years, vehicles for transportation of goods and peoples have been developed using electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator or a hydrogen fuel power cell. Furthermore, the vehicle may include a combination of an electric motor and conventional combustion engine. In general, an electric-vehicle battery, EVB, or traction battery is a battery used to power the propulsion of battery electric vehicles, BEVs. Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as a power supply for small electronic devices, such as cellular phones, notebook computers and camcorders, while high-capacity rechargeable batteries are used as a power supply for electric and hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e. g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy content, in particular for motor driving of a hybrid vehicle. That is, the battery module is formed by interconnecting the electrode terminals of the plurality of unit battery cells depending on a required amount of power and in order to realize a high-power rechargeable battery.

Battery modules can be constructed either in block design or in modular design. In block designs each battery is coupled to a common current collector structure and a common battery management system and the unit thereof is arranged in a housing. In modular designs, pluralities of battery cells are connected to form submodules and several submodules are connected to form the battery module. In automotive applications, battery systems often consist of a plurality of battery modules connected in series for providing a desired voltage. The battery modules may comprise submodules with a plurality of stacked battery cells and each stack comprising cells connected in parallel that are connected in series (*XpYs*) or cells connected in series that are connected in parallel (*XsYp*)*.*

A battery pack is a set of any number of (usually identical) battery modules. The battery modules may be configured in a series, parallel or a mixture of both to deliver the desired voltage, capacity, or power density. Components of battery packs include the individual battery modules, and the interconnects, which provide electrical conductivity between them.

A battery system further includes a battery management system (BMS), which is any electronic system that manages the rechargeable battery, battery module and battery pack, such as by protecting the batteries from operating outside their safe operating area, monitoring their states, calculating secondary data, reporting that data, controlling its environment, authenticating it and/or balancing it. For example, the BMS may monitor the state of the battery as represented by voltage (such as total voltage of the battery pack or battery modules, voltages of individual cells), temperature (such as average temperature of the battery pack or battery modules, coolant intake temperature, coolant output temperature, or temperatures of individual cells), coolant flow (such as flow rate, cooling liquid pressure), and current. Additionally, a BMS may calculate values based on the above items, such as minimum and maximum cell voltage, state of charge (SOC) or depth of discharge (DOD) to indicate the charge level of the battery, state of health (SOH; a variously-defined measurement of the remaining capacity of the battery as % of the original capacity), state of power (SOP; the amount of power available for a defined time interval given the current power usage, temperature and other conditions), state of safety (SOS), maximum charge current as a charge current limit (CCL), maximum discharge current as a discharge current limit (DCL), and internal impedance of a cell (to determine open circuit voltage).

The BMS may be centralized such that a single controller is connected to the battery cells through a multitude of wires. The BMS may be also distributed, wherein a BMS board is installed at each cell, with just a single communication cable between the battery and a controller. Or the BMS may be of modular construction including a few controllers, each handling a certain number of cells, with communication between the controllers. Centralized BMSs are most economical, least expandable, and are plagued by a multitude of wires. Distributed BMSs are the most expensive, simplest to install, and offer the cleanest assembly. Modular BMSs offer a compromise of the features and problems of the other two topologies.

A BMS may protect the battery pack from operating outside its safe operating area. Operation outside the safe operating area may be indicated in case of over-current, over-voltage (during charging), over-temperature, under-temperature, over-pressure, and ground fault or leakage current detection. The BMS may prevent operation outside the battery's safe operating area by including an internal switch (such as a relay or solid-state device) which is opened if the battery is operated outside its safe operating area, requesting the devices to which the battery is connected to reduce or even terminate using the battery, and actively controlling the environment, such as through heaters, fans, air conditioning or liquid cooling.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually comprise a battery management system, BMS, for obtaining and processing such information on system level and further a plurality of battery module managers, BMMs, which are part of the system's battery modules and obtain and process relevant information on module level. Particularly, the BMS usually measures the system voltage, the system current, the local temperature at different places inside the system housing, and the insulation resistance between live components and the system housing. Additionally, the BMMs usually measure the individual cell voltages and temperatures of the battery cells in a battery module.

Thus, the BMS/BMU is provided for managing the battery pack, such as by protecting the battery from operating outside its safe operating area, monitoring its state, calculating secondary data, reporting that data, controlling its environment, authenticating it and/or balancing it.

In case of an abnormal operation state, a battery pack shall usually be disconnected from a load connected to a terminal of the battery pack. Therefore, battery systems further comprise a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU using low current paths based on the feedback received from the BDU. The main functions of the BDU may thus include controlling current flow between the battery pack and the electrical system and current sensing. The BDU may further manage additional functions like external charging and pre-charging.

A secondary battery cell such as a lithium-ion battery cell comprises two electrodes located in an electrolyte solution. The electrodes are separated from each other by a separator made of an electrically insulating material (a so-called "dielectric"), which is, however, permeable for ions (e. g., Li⁺ ions in case of a lithium-ion battery) to allow these ions to freely move between these electrodes. However, in case of damage of the separator (e. g., caused by mechanical damaged to a mechanical impact on the battery cell or caused by an overload of the battery cell), the material of the separator may become ionized. Typically, a channel is then formed through the separator for a certain time, in which an electrically conductive plasma is created from the insulator material by heat and ionization. This situation is called a "dielectric breakdown." In certain situations, the dielectric breakdown may then continue to burn as an electric arc, causing an arc-fault of the affected battery cell.

Generally, automotive battery systems comprise voltage sources having a hazardous voltage level. Due to the nature of the application, dielectric breakdown caused by misuse or accident may happen and can then cause fire or explosion inside the battery system. In particular, the dielectric breakdown or ionization inside of a battery system may cause short circuit or electric arcing. However, in such a case, the arc needs a few seconds to take effect before it causes a damage.

Accordingly, there is a need for a method and a battery system that allow for a fast detection of the occurrence of electric arcing within a battery module. Further, there is a need for a method and a battery system allowing for disconnecting the battery module from a load upon detection of electric arcing inside the battery module. Also, there is a need for a vehicle equipped with one of the afore-mentioned a battery system to increase the safety of use.

It is thus an object of the present disclosure to provide a method and a battery system that allow for a fast detection of the occurrence of electric arcing within a battery module. Further, it is an object of the present disclosure to present a method and a battery system allowing for disconnecting the battery module from a load upon detection of electric arcing inside the battery module. Moreover, an objective of the present disclosure is to provide a vehicle equipped with one of the afore-mentioned a battery system to increase the safety of use.

### Summary of Invention

The invention is defined by the appended claims. The description that follows is subjected to this limitation. Any disclosure lying outside the scope of said claims is only intended for illustrative as well as comparative purposes.

The quintessence of the present disclosure is to describe a method and a battery system that allow for a detection of an arcing potential within a battery module prior to the occurrence of any hazardous situation. This is done by using existing measurements with an additional signal conditioning circuit configured to analyze frequency spectrum of these measurements or, more precisely, signals generated based on these measurements.

A first aspect of the present disclosure relates to a method for detecting the occurrence of a dielectric breakdown in a battery module, the method comprising the followings steps:
a) measuring at least one operation state of the battery module;
b) generating, for each of the operation states measured in step a), an operation signal corresponding to that measured operation state;
c) checking, for at least one of the operation signals generated in step a), whether the operation signal comprises a pattern that indicates the possible occurrence of an arc-fault within the battery module;
d) generating a warning signal upon detection, in step c), of an operation signal comprising a pattern that indicates the possible occurrence of an arc-fault within the battery module.

A second aspect of the present disclosure relates to a method for disconnecting a battery module from a load upon detection of a dielectric breakdown in a battery module, the method comprising the following steps:
- performing the method for detecting the occurrence of a dielectric breakdown in a battery module according to the first aspect;
- disconnecting the battery module from the load in response to the generation of a warning signal in step d) of the used method for detecting the occurrence of a dielectric breakdown in a battery module.

A third aspect of the present disclosure relates to a battery system, comprising:
a battery module comprising at least one battery cell;
a measurement means; and
a control unit;
wherein the measurement means is configured for performing the following steps of:
   A) measuring at least one operation state of the battery module, and
   B-1) generating, for each of the measured operation states, an operation signal corresponding to that measured operation state; and wherein the control unit is configured for performing the following steps of:
   B-2) receiving the operation signals from the measurement means;
   C) checking, for at least one of the received operation signals, whether the operation signal comprises a pattern that indicates the occurrence of an arc-fault within the battery module; and
   D) generating a warning signal upon detection, in step C), of an operation signal comprising a pattern that indicates the possible occurrence of an arc-fault within the battery module.

A fourth aspect of the present disclosure refers to a vehicle comprising at least one battery system according to the second aspect of the disclosure.

Further aspects of the present disclosure could be learned from the dependent claims or the following description.

One of the main advantages of the method and the battery system presented in the present disclosure is the capability to quickly detect unwanted developing ionization inside of the battery prior to catastrophic short circuit or arcing. In other words, an ionization occurring within a battery module (i. e., in at least one of its battery cells) is recognized already during its initial phase and thus that fast that a load can be electrically disconnected from the affected battery module before the battery module itself and/or the connected load would be damaged by a further continuing ionization processes within the battery module. By implementing signal conditioning circuit that analyzes frequency spectrum of suitable operation states of the battery module (such as current, voltage, or both), an ionization as well as an increasing conductivity path can be detected.

### Brief Description of the Drawings

Features will become apparent to those of ordinary skill in the art by describing in detail exemplary embodiments with reference to the attached drawings in which:
- Fig. 1: is a schematic 3-dimensional view of a typical design of a battery module according to the state of the art.
- Fig. 2: is a block diagram schematically illustrating the basic working principle of an embodiment of the method.
- Fig. 3: schematically illustrates example measurements of current during normal and during arcing.
- Fig. 4: schematically illustrates exemplary an extraction of amplitude values of current during arcing in time domain (A) and in frequency domain (B).
- Fig. 5: schematically illustrates several different embodiments of a battery system according to the present disclosure.
- Fig. 6: illustrates schematically the spectral analysis of an incoming signal using an analog circuit.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

In the following description of embodiments of the present disclosure, the terms of a singular form may include plural forms unless the context clearly indicates otherwise.

The electronic or electric devices and/or any other relevant devices or components according to embodiments of the present disclosure described herein may be implemented utilizing any suitable hardware, firmware (e. g., an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e. g., on a PCB or another kind of circuit carrier. The conducting elements may comprise metallization, e. g., surface metallizations and/or pins, and/or may comprise conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

A first aspect of the present disclosure relates to a method for detecting the occurrence of a dielectric breakdown in a battery module. The method comprising the followings steps:
a) measuring at least one operation state of the battery module;
b) generating, for each of the operation states measured in step a), an operation signal corresponding to that measured operation state;
c) checking, for at least one of the operation signals generated in step a), whether the operation signal comprises a pattern that indicates the possible occurrence of an arc-fault within the battery module;
d) generating a warning signal upon detection, in step c), of an operation signal comprising a pattern that indicates the possible occurrence of an arc-fault within the battery module.

In an embodiment of the method, at least one of the operations states measured in step a) is a current generated by the battery module or a current occurring in the battery module. Further, step b) comprises generating, as one of the operation signals, a current signal based on at least one of the operations states measured in step a) being a current. Moreover, step c) comprises checking, for at least one current signal generated in step b), whether the current signal comprises a pattern that indicates the occurrence of an arc-fault within the battery module.

In an embodiment of the method, at least one of the operations states measured in step a) is a voltage generated by the battery module or an electrical potential difference inside the battery module. Further, step b) comprises generating, as one of the operation signals, a voltage signal based on at least one of the operations states measured in step a) being a voltage. Moreover, step c) comprises checking, for at least one voltage signal generated in step b), whether the voltage signal comprises a pattern that indicates the occurrence of an arc-fault within the battery module.

It is understood that in embodiments of the method, an operation state being a current and an operation state being a voltage may be used at the same time.

In an embodiment of the method, step c) comprises the following sub-steps:
c-1) generating a frequency spectrum for at least one operation signal being a current signal and/or at least one voltage signal generated in step b); and
c-2) comparing at least one of the frequency spectra generated in step c-1) with a respective predefined reference frequency spectrum.

In step c-2), for each of the compared frequency spectra, an individual reference spectrum may be used provided especially for the comparison of that frequency spectrum with said reference frequency spectrum.

Of course, it suffices when the frequency spectrum is generated in a range of frequencies that are typically indicative for the occurrence of an arc-fault inside the battery module or the individual battery cells used in the battery module. For example, the frequency spectrum may only be generated for a frequency range between 10 kHz and 1000 kHz or a frequency range between 50 kHz and 500 kHz. Preferably, the generated frequency spectrum comprises, within its frequency domain, the frequency value of 100 kHz.

It is understood that in embodiments of the method, an operation state being a current and an operation state being a voltage may be used at the same time.

In an embodiment of the method, step c-2) comprises detecting, whether at least for one frequency value comprised in the reference frequency spectrum, the amplitude of the frequency spectrum generated in step c-1) exceeds the amplitude of the reference frequency spectrum at this frequency value. Further, step d) comprises generating the warning signal upon detection, in step c-2), of at least one frequency value comprised in the reference frequency spectrum, at which the amplitude of the frequency spectrum generated in step c-1) exceeds the amplitude of the reference frequency spectrum.

In embodiments of the method, frequency values, for which the amplitude of a measured frequency spectrum is compared with the amplitude of a respective reference spectrum may be values in a range between 10 kHz and 1000 kHz, preferably between 50 kHz and 500 kHz. Most preferably, the frequency value of 100 kHz is at least one of the frequency values, for which the amplitude of a measured frequency spectrum becomes compared with the amplitude of a respective reference spectrum.

In an embodiment of the method, step c-1) comprises performing a Fourier transform of at least a part of at least one current signal and/or at least one voltage signal generated in step b).

Then, for each of the performed Fourier transforms, the output of the Fourier transform is a spectrum given in the form of the amplitudes of the frequencies as a function over the frequencies of the operation signal having been Fourier transformed. In the present context, the phases of the frequencies, which could also be obtained from the Fourier transform, are not necessarily required.

In embodiments, the Fourier transform may be transformed over a time window (i. e., time range or time interval or range within the time domain) of a predefined length (i. e., duration) of the original operation signal. For example, if the predefined duration is denoted by ΔT, the control unit may be configured to perform, at a point in time t, the Fourier transform of the operation signal based on values in the operation signal measured in the time window [t-ΔT, t]. The Fourier transform (i. e., the generation of the frequency spectrum of an operation signal) can then be performed, in embodiments, continuously for each point t in time. In alternative embodiments, the Fourier transform of an operation signal may be performed only for discrete points in time. To perform a Fourier transform of an operation signal with regard to a time window [t-ΔT, t], amplitudes of the operation signal may be stored at least for sample points of the time window [t-ΔT, t].

In an embodiment of the method, for at least one operation signal being a current signal and/or a voltage signal, for which a Fourier transform is performed, the following sub-steps are performed:
- storing the amplitudes of the operation signal for a predefined number of sample points in time within a time window having a predefined duration;
- performing a fast Fourier transform based on the sample points and the stored amplitudes of the current.

The fast Fourier transform (FFT) provides an efficient and fast way to generate a frequency spectrum based on an operation signal.

In an embodiment of the method, step c) comprises the following sub-steps:
c-i) inputting, for at least one of the operation signals generated in step a), the operation signal to at least one bandpass filter;
c-ii) measuring, for each bandpass filter, the amplitude of the signal outputted from the bandpass filter;
c-iii) comparing, for each signal outputted in step c-ii), its amplitude with a predefined reference value associated with this output signal; and
wherein step d) comprises generating the warning signal upon detecting, in step c-iii), an amplitude of at least one of the outputted signals, which exceeds the associated predefined reference value.

In embodiments of the method, a plurality of bandpass filters may be used. The ranges of the bandpass filters are preferably pairwise disjunct or have only a partial overlap. Then, if the total number of bandpass filters is large (e. g., 10, 20, or more; such an arrangement may be referred to as a "filter bank"), the plurality of amplitudes of the signals outputted from the filters correspond at least to an approximation of a spectral analysis of the inputted operation signal. In other words, using a filter bank provides the possibility to obtain at least an approximation to a spectral analysis (Fourier transform) of the operation signal by using purely analog (non-digital) means. In this case, the spectral analysis is also performed continuously, i. e., for any point t in the time domain.

However, in embodiments, only few bandpass filters (e. g., 1 or 2 filters) may be used. Then, these bandpass filters must cover frequencies or at least one frequency that is most indicative of an arc-fault inside the battery module or inside a battery cell. For example, in an embodiment using only a single bandpass filter, this filter may be designed to let pass frequencies between 90 kHz and 110 kHz, when assuming that 100 kHz is a frequency highly suitable for indicating the occurrence of an arc-fault inside the battery module or one of its battery cells. In embodiments using 2 or more bandpass filters, it may be further checked subsequently to step c-iii), whether the exceeding of the amplitude of the output signal of at least two different filters with regard to their respective predefined reference values are correlated in time. Then, the risk for generating a false warning signal in step d) is reduced.

A second aspect of the present disclosure relates to a method for disconnecting a battery module from a load upon detection of a dielectric breakdown in a battery module, the method comprising the following steps:
- performing the method for detecting the occurrence of a dielectric breakdown in a battery module according to any one of claims 1 to 8;
- disconnecting the battery module from the load in response to the generation of a warning signal in step d) of the used method for detecting the occurrence of a dielectric breakdown in a battery module.

The disconnection may be performed using at least one switch. For example, the battery module may be connected to the load by means of two electric lines, a first electric line connecting the load with a first terminal of the battery module, the second electric line connecting the load with a second terminal of the battery module. The first terminal may be a negative terminal (negative pole) of the battery module and the second terminal may be a positive terminal (positive pole) of the battery module. Alternatively, the first terminal may be a positive terminal (positive pole) of the battery module and the second terminal may be a negative terminal (negative pole) of the battery module. Then, the first line may comprise a first switch. In such embodiments of the method for disconnecting a battery module from a load, the step of disconnecting the battery module from the load may comprise a sub-step of sending a signal to the first step to interrupt the electric connection of the first line.

In embodiments of the method according to the second aspect, also the second line may comprise a second switch. In such embodiments of the method for disconnecting a battery module from a load, the step of disconnecting the battery module from the load may comprise a first sub-step of sending a signal to the first switch to interrupt the electric connection of the first line and further comprise a second sub-step of sending a signal to the second to the second switch to interrupt the electric connection of the second line.

In embodiments of the method according to the second aspect, the warning signal may comprise a signal to be sent to the first switch to electrically interrupt the first line. In embodiments, the warning signal may comprise a first signal to be sent to the first switch to electrically interrupt the first line and a second signal to be sent to the second switch to electrically interrupt the second line. In embodiments, the warning signal may further comprise a signal to be sent to an alarm means configured for producing an alarm signal perceptible by a human, e. g., an acoustic signal or an optical signal.

A third aspect of the present disclosure relates to a battery system, comprising: a battery module comprising at least one battery cell; a measurement means; and a control unit. The measurement means is configured for performing the following steps of:
A) measuring at least one operation state of the battery module, and
B-1) generating, for each of the measured operation states, an operation signal corresponding to that measured operation state.

Further, the control unit is configured for performing the following steps of:
B-2) receiving the operation signals from the measurement means;
C) checking, for at least one of the received operation signals, whether the operation signal comprises a pattern that indicates the occurrence of an arc-fault within the battery module; and
D) generating a warning signal upon detection, in step C), of an operation signal comprising a pattern that indicates the possible occurrence of an arc-fault within the battery module.

In embodiments of the battery module according to the third aspect, at least one of the operation states is a current generated by the battery module or a current occurring in the battery module. The measurement means comprises a current sensor configured for measuring said current. The current sensor is configured for generating a current signal corresponding to the current measured by the current sensor, the current signal corresponding to one of the operation signals generated by the measurement means. The control unit is configured for checking, whether the current signal comprises a pattern that indicates the occurrence of an arc-fault within the battery module.

In embodiments of the battery system, the current sensor may be connected in series with the battery module. In this case, the current generated by the complete battery module is measured, and an operation state corresponds to the current generated by the complete battery module.

In alternative embodiments, the current sensor may be connected in series with of one of the battery cells comprised in the battery module. In this case, an operation state corresponds to the current measured by this current sensor.

In embodiments, one operation state may correspond to a current measured by a sensor connected in series with the battery module, and one or more further operation states may correspond to respective currents measured by current sensors each connected in series with one of the battery cells comprised in the battery module. In such embodiments, the control unit may check the current signal of each of these current sensors for patterns indicating an occurrence of an arc-fault within the battery module.

In embodiments of the battery module according to the third aspect, at least one of the operation states is a voltage generated by the battery module or an electrical potential difference inside the battery module. The measurement means comprises a voltage sensor configured for measuring said voltage. The voltage sensor is configured for generating a voltage signal corresponding to the voltage measured by the voltage sensor, the voltage signal corresponding to one of the operation signals generated by the measurement means. The control unit is configured for checking, whether the voltage signal comprises a pattern that indicates the occurrence of an arc-fault within the battery module.

In embodiments of the battery system, the voltage sensor may be connected in parallel with the battery module. In this case, the voltage generated by the complete battery module is measured, and an operation state corresponds to the voltage generated by the complete battery module.

In alternative embodiments, the voltage sensor may be connected in parallel with of one of the battery cells comprised in the battery module. In this case, an operation state corresponds to the voltage measured by this voltage sensor.

In embodiments, one operation state may correspond to a voltage measured by a sensor connected in parallel with the battery module, and one or more further operation states may correspond to respective voltages measured by voltage sensors each connected in parallel to one of the battery cells comprised in the battery module. In such embodiments, the control unit may check the current signal of each of these current sensors for patterns indicating an occurrence of an arc-fault within the battery module.

In embodiments of the battery module according to the third aspect, the control unit is configured for performing the following steps:
C-1) generating a frequency spectrum of at least one operation signal corresponding to a current signal or a voltage signal;
C-2) comparing at least one of the frequency spectra generated in step C-1) with a respective predefined reference frequency spectrum.

In step C-2), for each of the compared frequency spectra, an individual reference spectrum may be used provided especially for the comparison of that frequency spectrum with said reference frequency spectrum.

As to the characteristics of the frequency spectra, see the corresponding remarks above in the context of described embodiments the method for detecting the occurrence of a dielectric breakdown in a battery module.

In embodiments, the control unit may in particular be configured for:
- detecting, while comparing a generated frequency spectrum with its respective reference spectrum according to step C-2), whether at least for one frequency value comprised in the reference frequency spectrum, the amplitude of the generated frequency spectrum exceeds the amplitude of the reference frequency spectrum at this frequency value;
- generating and outputting a warning signal upon a detection of at least one frequency value comprised in a generated reference frequency spectrum, at which the amplitude of the generated frequency spectrum exceeds the amplitude of the respective reference frequency spectrum.

In embodiments of the battery module, frequency values, for which the amplitude of a measured frequency spectrum is compared with the amplitude of a respective reference spectrum may be values in a range between 10 kHz and 1000 kHz, preferably between 50 kHz and 500 kHz. Most preferably, the frequency value of 100 kHz is at least one of the frequency values, for which the amplitude of a measured frequency spectrum becomes compared with the amplitude of a respective reference spectrum.

In embodiments of the battery module, the control unit may be configured for performing a Fourier transform of at least a part of at least one current signal and/or at least one voltage signal generated in step B-1).

As to the characteristics of the Fourier transform, see the corresponding remarks above in the context of described embodiments the method for detecting the occurrence of a dielectric breakdown in a battery module.

In embodiments of the battery module, the control unit may be in particular configured for performing a fast Fourier transform (FFT) of at least a part of at least one current signal and/or at least one voltage signal generated in step B-1). In such embodiments, the control unit may also be configured for:
- storing the amplitudes of the operation signal for a predefined number of sample points in time within a time window having a predefined duration;
- performing a fast Fourier transform based on the sample points and the stored amplitudes of the current.

In alternative embodiments of the disclosed battery module, the battery module comprises at least one bandpass filter bank, each of the bandpass filter banks comprising at least one bandpass filter. The at least one bandpass filter bank may be integrated in the control unit. Then, each of the filter banks is configured for taking as input one of the operation signals generated by the measurement means. In such embodiments, the control unit is further configured to measure the output of each of the bandpass filters of each of the filter banks. Therefore, a further measurement means may be used. Moreover, the control unit is configured for:
- comparing, for each signal outputted from a bandpass filter, its amplitude with a predefined reference value associated with this output signal; and
- generating the warning signal upon detecting an amplitude of at least one of the signals outputted from a bandpass filter, which exceeds the associated predefined reference value.

As to the number and use of the bandpass filters, see the corresponding remarks above in the context of described embodiments the method for detecting the occurrence of a dielectric breakdown in a battery module.

In embodiments of the battery module according to the third aspect, the battery module further comprises: a first terminal connected, via a first electrical line to the at least one battery cell; a second terminal connected, via a second electrical line to the at least one battery cell; a first switch configured for interrupt the first line upon receiving a first interruption signal; and a second switch configured for interrupting the second line upon receiving a second interruption signal. The control unit is configured for:
- sending, when generating a warning signal according to step D), a first interruption signal to the first switch; and/or
- sending, when generating a warning signal according to step D), a second interruption signal to the second switch.

A fourth aspect of the present disclosure relates to a vehicle comprising at least one battery system according to the third aspect.

Preferably, the vehicle is a hybrid vehicle or a fully electric vehicle.

In embodiments of the vehicle according to the fourth aspect, the vehicle comprises an alarm means configured for producing an alarm signal perceptible by a human, e. g., an acoustic signal or an optical signal. For example, if the vehicle is a car, the alarm means may be installed in the passenger cabin of the car. In such embodiments, the control unit may be further configured for sending, when generating a warning signal according to step D), a signal to the car's alarm means in order to trigger the alarm means. Alternatively, the vehicle may comprise a central vehicle control unit, and the control unit of the battery module may be further configured for sending, when generating a warning signal according to step D), an alarm signal to the central vehicle control unit. Then, upon receiving the alarm signal from the control unit of the battery module, the central vehicle control unit may send a signal to the car's alarm means in order to trigger the alarm means.

### Specific Embodiments

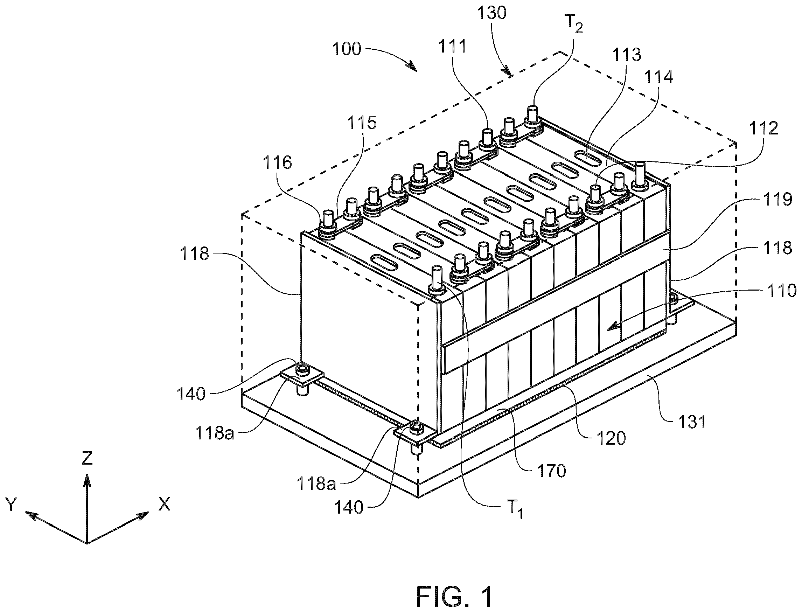

Figure 1 is a schematic 3-dimensional view of a typical design of a battery module according to the state of the art. Referring to Fig. 1, an exemplary embodiment of a conventional battery module 100 includes a plurality of battery cells 110 aligned in one direction (the x-direction with reference to Fig. 1). A heat exchange member 170 may also be provided adjacent to a bottom surface of the plurality of battery cells 110. Further, a pair of end plates 118 are provided to face wide surfaces of the battery cells 110 at the outside of the battery cells 110, and a connection plate 119 is configured to connect the pair of end plates 118 to each other, thereby also fixing the plurality of battery cells 110 together. Fastening portions 118a on both sides of the battery module 100 are fastened to a support plate 131 by bolts 140. The support plate 131 is part of a housing 130.

Here, each battery cell 110 is an essentially prismatic or essentially cuboidal-shaped cell, the wide flat surfaces of the cells being stacked together to form the battery module. Further, each battery cell 110 includes a battery case configured for accommodation of an electrode assembly and an electrolyte. The battery case is hermetically sealed by a cap assembly 114. The cap assembly 114 is provided with positive and negative electrode terminals 111 and 112 having different polarities, and a vent 113. The positive electrode T₁ of the first battery cell (when viewed along the x-axis) forms the positive terminal of the battery cell stack. Correspondingly, the negative electrode T₂ of the last battery cell (when viewed along the x-axis) forms the negative terminal of the battery cell stack. As the illustrated battery module 100 only comprises a single battery cell stack, the terminal T₁ at the same time forms the positive electrode of the complete battery module 100, and the terminal T₂ at the same time forms the negative electrode of the complete battery module 100. The vent 113 is a safety means of the battery cell 110, which acts as a passage through which gas generated in the battery cell 110 is exhausted to the outside of the battery cell 110. The positive and negative electrode terminals 111 and 112 of neighboring battery cells 110 are electrically connected through a bus bar 115, and the bus bar 115 may be fixed by a nut 116 or the like. Hence, the battery module 100 may be used as power source unit by electrically connecting the plurality of battery cells 110 as one bundle.

Usually, the battery cells 110 generate a large amount of heat while being charged/discharged. The generated heat is accumulated in the battery cells 110, thereby accelerating the deterioration of the battery cells 110. Therefore, the battery module 100 further includes a heat exchange member 170, which is provided adjacent to the bottom surface of the battery cells 110 so as to cool down the battery cells 110. In addition, an elastic member 120 made of rubber or other elastic materials may be interposed between the support plate 131 and the heat exchange member 170.

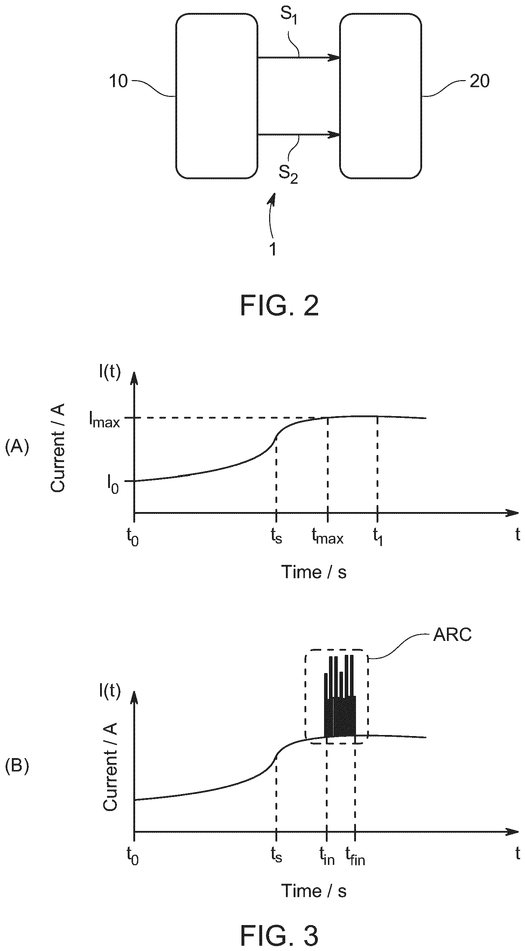

Figure 2 is a block diagram schematically illustrating the basic working principle of an embodiment of the method for detecting the occurrence of a dielectric breakdown in a battery module according to the present disclosure as well as a corresponding battery system.

Specifically, the diagram illustrates a battery system 1 according to the present disclosure, which comprises a battery module 10 and a control unit 20. The battery module 10 comprises a plurality of battery cells. The battery cells may be arranged in at least one battery cell stack. For example, the battery module 10 may correspond to the battery module 100 as shown in Fig. 1. However, it is understood that other internal arrangements of the battery cells can also be used inside of the battery module 10, e. g., configurations, wherein the battery module 10 comprises a plurality of battery cell stacks.

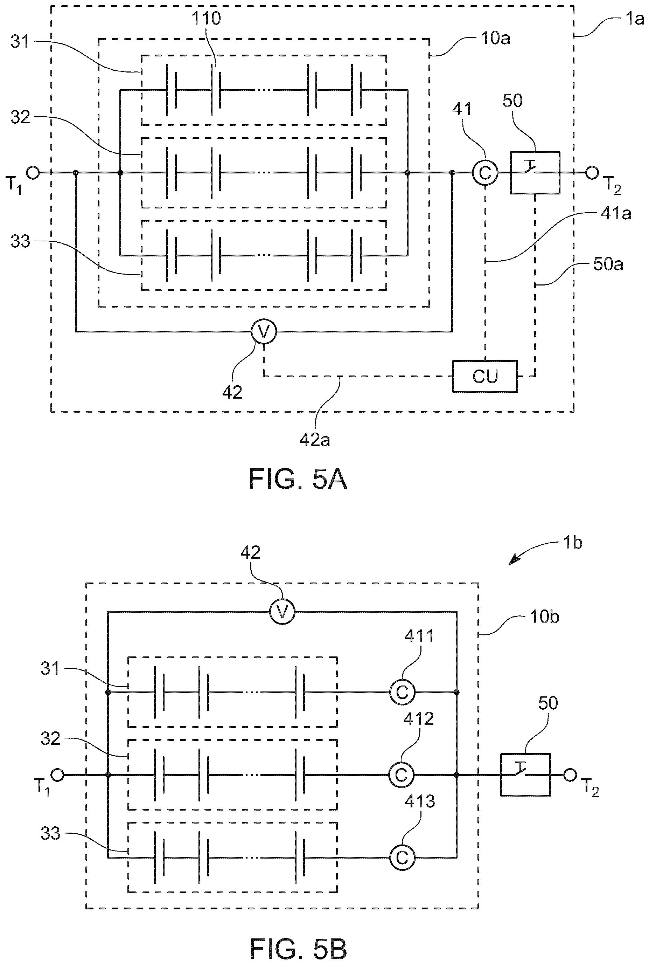

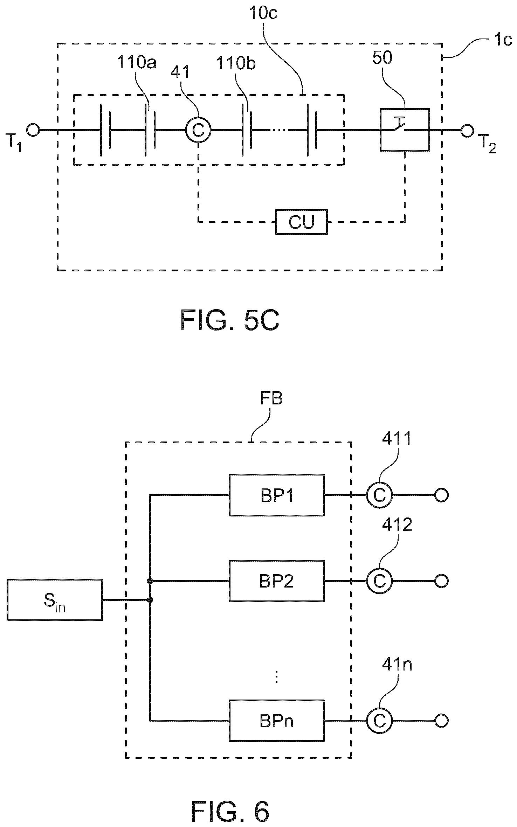

In the exemplary embodiment of the battery system 1 shown in Fig. 2, the battery system 1 is configured to monitor two different operation states of the battery module 10, viz. a current generated by the battery module 10 and the voltage generated by the battery module 10. Therefore, a measurement means (not shown in Fig. 2) having respective sensors (not shown) is implemented into the battery system 1, the sensors each being configured for measuring one of the operation states to be measured. Since here, a current and a voltage generated by the battery module 10 are to be measured, the measurement means of the battery system 1 comprises a current sensor 41 (not shown) as well as a voltage sensor (not shown). If, for example, the battery module 10 corresponds to the battery module 100 illustrated in Fig. 1, the current sensor 41 may be arranged in series with the battery cell stack depicted in Fig. 1 (i. e., either electrically connected to the first terminal T₁ or electrically connected to the second terminal T₂ of the depicted battery cell stack). Also, the voltage sensor 42 may be arranged in parallel to the depicted battery cell stack (i. e., electrically connected with both, the first terminal T₁ and the second terminal T₂). However, in particular, if the battery module 10 internally is assembled different from the assembly of the battery module 100 of Fig. 1, the current sensor 41 and/or the voltage sensor 42 may be arranged otherwise within the battery module 10. This will be explained in more detail below with reference to Fig. 5.

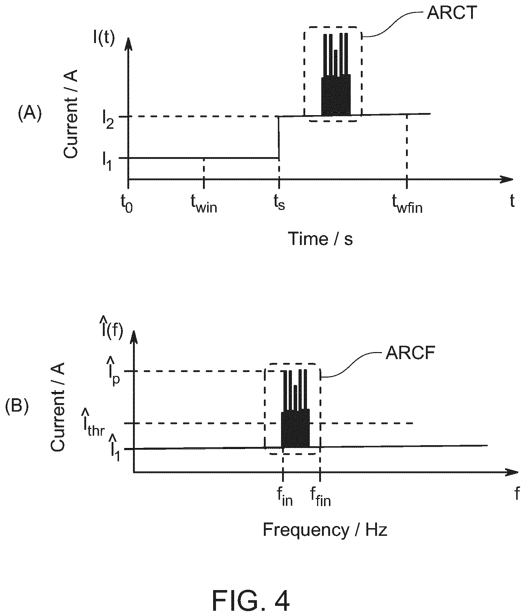

Each of the sensors generates a signal (operation signal) corresponding to the operation state of the battery module 10 measured by the sensor. Hence, in the example of Fig. 2, the current sensor 41 generates an operation signal corresponding to the measured current (this operation signal in the following referred to as current signal), and the voltage sensor 42 generates an operation signal corresponding to the measured voltage (the latter operation signal in the following referred to as voltage signal). Further, the control unit 20 is configured to receive each of the operation signals generated by the sensors of the measurement means. Hence, in the present embodiment, the control unit 20 is configured to receive the current signal S₁ from the current sensor 41 and to receive the voltage signal S₂ from the voltage sensor 42. Further, the control unit 20 is configured for evaluating the received operation signals, and in particular for detecting, whether at least one of these operation signals exhibits a pattern indicating and arc-fault occurring within the battery module 10, i. e., in at least one of the battery cells comprised in the battery module 10. The afore-mentioned evaluation of the received operation signals and detection of patterns indicating a possible arc-fault will be described in more detail with the help of the following Figs. 3 and 4.

Automotive battery systems generally provide or accept continuously changing currents. However, as the electrically connected systems (loads) have each a certain inductance, the current demand and/or the current supply does usually not change abrupt (i. e., in a discontinuous way with respect to time) but changes only within a certain window. Therefore, the change of the intensity of current (amperage) with respect to time does never exceed a defined level of derivation, or equivalently, using a formula, when the intensity of the current is expressed as a function I(t) of the time t, it holds | dl(t) / dt | ≤ c with c > 0 being a known constant.

This is illustrated schematically in the diagram of Figure 3A showing an exemplary course of an intensity of current (the diagram's ordinate) provided by a battery module as a function over the time t (abscissa of the diagram). As indicated in the diagram, the current may be measured in ampère (A), and the time may be given in seconds (s), although this is not relevant in the present case, since the diagram is only illustrative. In the example, the value of the intensity of current is I₀ at the point in time I₀. At this time t₀, the demand of current required by a load connected to the battery module may increase. Hence, the current provided by the battery module increases accordingly until it reaches a maximum value Iₘₐₓ at the time tₘₐₓ, where Iₘₐₓ may correspond to the current supply required by the load. However, as can be taken from the diagram, the current supplied by the battery module is not increased constantly (i. e., the function I(t) is not linear in the range between t₀ and tₛ). Rather, when starting at t₀, the current at first only slightly increases, and then, the increase is performed faster until the current reaches its maximum value at the time tₛ. After the point in time tₛ, the increase of the current is slowed down again before it reaches its maximum value at tₘₐₓ. After the time tₘₐₓ, the intensity of current remains approximately constant (see the region around the time t₁). However, as can be taken from Fig. 3A, the (absolute value of the) change | dl(t) / dt | of the intensity of the current I(t), i. e., the slope of the graph depicted in the diagram, does never exceed the value of the slope at the time tₛ.

While Fig. 3A illustrates the course of a current with respect to time when the battery module is in a normal state of operation, the course of the current will be significantly different from that when an arc-fault occurs within at least one of the battery cells of the battery module. This is schematically illustrated in Figure 3B, showing essentially the same diagram as Fig. 3A, with the difference, however, that an arc-fault event occurs in the battery module. In case of arcing, the intensity of the current changes extremely fast within a short period of time. This is schematically illustrated in Fig. 3B by the behavior of the graph shown in the region ARC (between the points in time tᵢₙ and t_{fin}), where the function I(t) changes very quickly (in comparison to the normal behavior of the function as illustrated in Fig. 3A) between various rather different values of the intensity of current. Consequently, in the event of arcing, the derivative of the intensity of current with respect to time by far exceeds the maximum value of the derivative that could be reached in case of a normal operation of the battery module as explained above. In other words, for certain times t, absolute derivative values | dl(t) / dt | > c will occur during arcing with c > 0 being the above-explained maximum boundary for the absolute values of the derivative of the intensity of current with respect to time.

However, as already indicated above with respect to the region ARC in the diagram of Fig. 3B, not only a single abrupt change of the intensity of current is experienced in case of arcing but also a very fast change between higher and lower values of the intensity current. In other words, the arcing current is not regulated and occurs without (approximately) linear increment. Consequently, when looking at a spectral representation of the intensity of current as a function over time as shown in Fig. 3B, there will be frequencies with a significant amplitude, these frequencies corresponding to the fast changes of the current caused by the arcing as described before. For example, frequencies indicative for arcing may occur in a certain frequency around 100 kHz. Hence, in the event of an arc-fault in the battery module, a frequency representation of the intensity of current will comprise exhibit very high amplitudes for frequencies being typically caused by arcing. Accordingly, an arcing event can be detected by filtering noise, adding data window based search and observing certain patterns in the frequency spectrum.

Figure 4A is a diagram rather similar to that of Fig. 3B. Specifically, the intensity of a current (ordinate of the diagram) supplied by a battery module is schematically illustrated by a function over time (abscissa of the diagram). The actual current demand of the load connected to the battery module is indicated by the straight horizontal lines (corresponding current intensities of I₁ and I₂, respectively) of the curve depicted in Fig. 4A. At the beginning with time the load of the battery module may be caused by a certain device electrically connected to the battery, wherein the device demands a constant current supply. Then, at the point in time tₛ, a further device may be switched on such that the demand of the load becomes relatively fast increased at this time tₛ, which is indicated here, for the sake of simplicity, by a step of the depicted curve at the time tₛ, although in reality, the step shows a flattened shape with a maximum derivative not exceeding a certain boundary value, as explained before in the context of Fig. 3. After the time tₛ, a high-frequent change in the course of the intensity of current is experienced (indicated in the diagram by the region ARCT), which may be indicative to an arc-fault event occurring in the battery module.

The diagram of Figure 4B schematically illustrates a spectral representation of the intensity of current as shown in the diagram of Fig. 4A. In other words, the function in the diagram of Fig. 4B may be obtained by means of a Fourier transform of the function illustrated in Fig. 4A. Hence, while the intensity of current is represented in Fig. 4A as a function I(t) over time t (i. e., over the "time domain"), the intensity of current is represented in Fig. 4B as a function Î(f) over the frequency f (i. e., over the "frequency domain"). As only the (absolute values of the) amplitudes Î(f) of the frequencies f are shown in Fig. 4B, the diagram of Fig. 4B may not be fully equivalent to the diagram of Fig. 4A, since the phases are omitted in Fig. 4B. Also, please note that both, Fig. 4A and Fig. 4B are merely illustrative, i. e., the function Î(f) shown in Fig. 4B may not be an exact spectral representation of the function I(t) of Fig. 4A.

The spectral analysis to generate the diagram of Fig. 4B based on the information provided in the diagram of Fig. 4A may have been performed using the data in the time-window between t_{win} and t_{wfin}, including the point in time tₛ. Hence, due to the sudden step-like increase of the intensity of current appearance in the time domain at the time tₛ (see Fig. 4A), the spectral representation exhibits a certain minimum amplitude Î₁ for all frequencies f in the illustrated frequency range. In reality (i. e., with a flattened step of the intensity of current in the time domain; see above), this "background" may not be constant over the frequency domain but, e. g., slightly decreasing instead, as the frequency f increases. Also, of course, other shapes of the amplitudes Î(f) of the shown spectral representation as a function of the frequency f are possible. However, in any cases of the normal operation of the battery module, the amplitudes Î(f) are each bounded by a certain maximum value Îₘₐₓ(f), which may be frequency-dependent, i. e., be given as a function of the frequency f. In the example of Fig. 4B, it may be set Îₘₐₓ(f) = Î₁ = *const.* However, in general, as said before, the boundary for the maximum value of an amplitude during normal operation of the battery module may depend on the frequency f, i. e., there is a boundary function Îₘₐₓ(f) > 0 such that it holds Î(f) ≤ Îₘₐₓ(f) for all frequencies or at least for each frequency f within a relevant frequency range.

However, as can be seen from Fig. 4B, this is not the case for the function shown in the diagram of Fig. 4B. Rather, in a frequency range between fᵢₙ and f_{fin}, the amplitudes Î(f) of the shown spectral representation Î(f) as a function of the frequency f show fierce changes in close density (see the region indicated as ARCF in Fig. 4B), which may be considered as analogon of the behavior of the intensity of current I(t) in the region ARCT when viewed in the time domain (see Fig. 4A). Specifically, in the region ARCF, there are frequencies having an amplitude by far larger than that of the "background" amplitude Î₁ in the present example. Hence, the relation Î(f) ≤ Îₘₐₓ(f) = Î₁ does no longer hold in the illustrated example, since there are frequency values f having an amplitude Î(f) > Î₁. Accordingly, the noise in the region ARCT of the diagram of Fig. 4A (showing the intensity of current with respect to the time domain) can be detected simply by checking, with respect to the spectral representation of the intensity of current, whether the relation Î(f) ≤ Îₘₐₓ(f) is infringed for at least some frequency values f being typically caused by arcing, or, equivalently, whether the relation Î(f) ≤ Îₘₐₓ(f) holds at least for some frequency values f typically caused by arcing.

However, due to natural or usual variations in the frequency that may occur without an arc-fault event being present, using the relation Î(f) ≤ Îₘₐₓ(f) for the detection of arc-faults as described before may be too sensitive a check, resulting in an increased likelihood of false-positive detections of arc-faults and/or false alarms. Hence, to avoid excessive sensitivity, it may preferably be checked instead, whether the relation Î(f) ≤ Îₜₕᵣ(f) is infringed with a predefined threshold amplitude Îₜₕᵣ(f) (with may again be frequency-dependent, i. e., be given as a function of the frequency f), wherein Îₘₐₓ(f) < Îₜₕᵣ(f) for all frequencies f in a relevant frequency range, while at the same time, Îₜₕᵣ(f) is chosen smaller than the typical peaks (or expected peaks) in the amplitudes of the spectral representation of the current intensity during an arc-fault event. This is schematically illustrated in the example of Fig. 4B by a (constant) threshold amplitude Îₜₕᵣ with Îₘₐₓ(f) = Î₁ < Îₜₕᵣ < Î_{P}, where Î_{P} denotes a value of typical peaks of the amplitude of the spectral representation of the intensity of current Î(f) in case of an arc-fault event.

Hence, one of the afore-described checks (i. e., with the notations as defined above, the check, whether the relation Î(f) ≤ Îₘₐₓ(f) is infringed or, alternatively, the check whether the relation Î(f) ≤ Îₜₕᵣ(f) is infringed) may be implemented in embodiments of the method for detecting the occurrence of a dielectric breakdown in a battery module. In such embodiments, at least one of the measured operational states of the battery module is a current measured, by a current sensor 41, within the battery module, and the operation signal is a current signal generated by the current sensor 41 or at least the signal equivalent to the current signal (e. g., the original current signal multiplied by a certain constant factor for the sake of scaling etc.).

Of course, also other operation states of a battery module may be measured and checked in a similar way in alternative embodiments of the method according to the present disclosure. Specifically, a measured voltage may be used instead of a measured current in alternative embodiments of the present disclosure. In preferred embodiments, a voltage as well as a current is measured in the battery module, and two operation states of the battery module, viz. the measured voltage and the measured current become monitored and checked during the operation of the battery module.

The monitoring of the operation states can be performed permanently, i. e., continuously for each time t in the time domain. In alternative embodiments, checks are only performed repeatedly for discrete points within the time domain. In any case, it is necessary that a monitored operation state of the battery module (such as a current and/or a voltage) is measured for certain time-window of the predefined length in order to transform the measurement into a spectral representation.

In order to be able to perform the afore-described check upon the operation signals (e. g., a current and/or voltage measured within the battery module), the control unit must be configured such that a transform of the time-dependent input signal based on a measured operation state into a spectral representation can be done. In embodiments, this may be done digitally, e. g., by storing the values of an input operation signal (e. g., a current signal and/or a voltage signal) for a predefined time duration ΔT, and subsequently using the stored values as input for a Fourier transform performed by a CPU or microcontroller. In alternative embodiments, a spectral representation of the input signal may be performed by means of analog technology such as a filter bank. The letter will be described in more detail below with reference to Fig. 6.

Figure 5 schematically illustrates several different embodiments of a battery system according to the present disclosure. Specifically, Fig. 5A illustrates a battery system 1a comprising a battery module 10a with three battery cell stacks 31, 32, 33. Each of the battery cell stacks 31,32, 33 comprises a plurality of battery cells 110. In the example of Fig. 5A, the three battery cell stacks 31, 32, 33 are electrically connected in parallel. Connected in series to the battery module 10a (i. e., to the ensemble of the three battery cell stacks 31, 32, 33 being connected in parallel) is a current sensor 41. Further, a voltage sensor 42 is connected in parallel to the battery module 10a. Accordingly, if at least one of the battery cells 110 comprised in the battery module 10a (i. e., in one of the battery cell stacks 31, 32, 33) undergoes a developing ionization in conjunction with electric arcing, the above-described effects of high-frequent changes in current as well as in voltage will superimpose to the current and voltage generated by the complete assembly of the three battery cell stacks 31, 32, 33 and will then be measured by both, the current sensor 41 as well as the voltage sensor 42.

As a result of these measurements, operation signals are then transmitted to the control unit CU of the battery system 1a. Specifically, a current signal is transferred via a first signal line 41a to the control unit CU, and a voltage signal is transferred via a second signal line 42a to the control unit CU. Then, the control unit CU evaluates these operation signals by means of the method as described before with reference to Figs. 3 and 4. In particular, the control unit CU checks the incoming operation signals on patterns that may indicate arcing inside the battery module 10a. Upon detection of such a pattern, the control unit CU generates a warning signal, which is used, in the illustrated example, to operate the switch 50 so as to disconnect the battery module 10a from a load (not shown), which may be connected to the battery module 10a by means of the terminals T₁, T₂. In another embodiment, a further switch (not shown) may be provided between the battery module 10a and the first terminal T₁, the further switch 50 operated analogously to the shown switch 50 by the control unit CU. Then, both terminals T₁, T₂ of the battery module 10a will be disconnected upon detection of an arc-fault inside the battery module 10a.

An alternative embodiment of a battery system 1b according to the present disclosure is illustrated in Fig. 5B. As in the example of Fig. 5A, the battery system 1b comprises a battery module 10b equipped with three battery cell stacks 31, 32, 33 connected in parallel to each other. However, in this example, the operation states used for checking on occurring arc-faults inside the battery module 10b are measured differently in comparison to the example of Fig. 1A. In particular, the intensity of current as well as the voltage are measured in the illustrated example individually for each of the battery cell stacks 31, 32, 33. Specifically, a first current sensor 411 is connected in series with the first battery cell stack 31, and correspondingly, a second current sensor 412 and a third current sensor 413 are connected in series with the second battery cell stack 32 and the third battery cell stack 33, respectively. Furthermore, a voltage sensor 42 is installed in parallel to the assembly of battery cell stacks 31, 32, 33, which is comparable to the arrangement of the voltage sensor 42 in the example of Fig. 5A.

Accordingly, in the example of Fig. 5B, the current generated by each of the battery cell stacks 31, 32, 33 can be measured individually such that in case of the occurrence of an arc-fault inside the battery module 10a, it could be detected, which of the battery cell stacks 31, 32, 33 contains the battery cell affected by the arc-fault.

Each of the current sensors 411, 412, 413 as well as the voltage sensor 42 is connected via the respective signal line to a control unit. For the sake of simplicity, the control unit and the signal lines are not shown in Fig. 5B. Again, the control unit is configured to evaluate the operation signals by means of the method as described before with reference to Figs. 3 and 4 and to generate a warning signal, which is used, in the illustrated example, to operate the switch 50 so as to disconnect the battery module 10b from a load (not shown), which may be connected to the battery module 10b by means of the terminals T₁, T₂. Again, a second switch (not shown) operated in a similar way as the shown switch 50 may be implemented in embodiments to disconnect the battery module 10b from the second terminal T₂.

Further, Figure 5C illustrates schematically a further possibility to arrange an operational sensor inside the battery module. Specifically, a further embodiment of the battery system 1c comprises a battery module 10c having only a single battery cell stack. For example, the battery module 10c may correspond to the battery module 100 shown in Fig. 1. In the example, the current sensor 41 is not connected in series with the battery module 10c but rather arranged inside the stack of battery cells of the battery module 10c between two adjacent battery cells 110a and 110b. Again, the signal produced by the current sensor 41 is transmitted to the control unit CU being configured to operate the switch 50 so as to disconnect the battery module 10c from a load, which may be connected to the battery module 10c via the terminals T₁, T₂ upon detection of an arc-fault inside the battery module 10c.

Figure 6 illustrates schematically how to perform the spectral analysis of an incoming signal Sᵢₙ using an analog circuit. The input signal Sᵢₙ may be one of the operation signals generated by measurement means / measurement sensors of embodiments of the battery system according to the present disclosure. Here, an input signal Sᵢₙ becomes inputted to a filter bank FB comprising a plurality of bandpass filters BP1, BP2, ..., BPn. The passing ranges of the bandpass filters BP1, BP2, ..., BPn may be pairwise disjunct in embodiments of the depicted analytics circuit. However, in embodiments, the passing ranges of the bandpass filters BP1, BP2, ..., BPn may partially overlap. Then, the first bandpass filter BP1 lets pass frequencies within a certain range around the first frequency, the second bandpass filter BP2 lets pass frequencies within a certain range around second frequency unlike to the first frequency, etc. Subsequently, the amplitudes of the signals having passed the bandpass filters BP1, BP2, ..., BPn are measured by respective current sensors 411, 412, 41n. This way, at least an approximation of the spectral representation of the incoming input signal Sᵢₙ is generated by the circuit depicted in Fig. 6. Hence, the circuit of Fig. 6 may be used in embodiments of the battery system according to the present disclosure to generate a spectral representation of an operation signal.

### Reference signs

- 1: battery system
- 1a, 1b, 1c: battery systems
- 10: battery module
- 10a, 10b, 10c: battery modules
- 20: control unit
- 31, 32, 33: battery cell stacks
- 41: current sensor
- 42: voltage sensor
- 50: switch
- 100: battery module (state of the art)
- 110: battery cells
- 111: positive electrode
- 112: negative electrode
- 113: vent
- 114: cap assembly
- 115: bus bar
- 116: nut
- 118: end plates
- 118a: fastening portion
- 130: housing
- 131: support plate
- 140: bolts
- 170: heat exchange member
- 411, 412, 413, 41n: current sensors
- ARC, ARCT: region of an intensity of current as a function over the time domain
- ARCF: region of an intensity of current as a function over the frequency domain
- BP1, BP2, BPn: bandpass filters
- CU: control unit
- f: frequency
- fᵢₙ, f_{fin}: frequency values
- FB: filter bank
- I(t): intensity of current as function over the time domain
- I₀, I₁, I₂, Iₘₐₓ: values of the intensity of current
- Î(f): amplitude of the intensity of current as a function over the frequency domain (in a spectral representation)
- Î₁, Îₜₕᵣ, Î_{P}: amplitudes of the intensity of current
- S₁: current signal
- S₂: voltage signal
- Sᵢₙ: incoming operation signal
- t: time
- t₀, tₛ, t₁: points in time
- t_{win}, t_{wfin}: points in time
- T₁, T₂: terminals
- x, y, z: axes of a Cartesian coordinate system

## Claims

1. A method for detecting the occurrence of a dielectric breakdown in a battery module (10), the method comprising the followings steps:
a) measuring at least one operation state of the battery module (10);
b) generating, for each of the operation states measured in step a), an operation signal corresponding to that measured operation state;
c) checking, for at least one of the operation signals generated in step a), whether the operation signal comprises a pattern that indicates the possible occurrence of an arc-fault within the battery module;
d) generating a warning signal upon detection, in step c), of an operation signal comprising a pattern that indicates the possible occurrence of an arc-fault within the battery module (10).

2. The method of claim 1,
wherein at least one of the operations states measured in step a) is a current generated by the battery module (10) or a current occurring in the battery module (10);
wherein step b) comprises generating, as one of the operation signals, a current signal (S₁) based on at least one of the operations states measured in step a) being a current; and
wherein step c) comprises checking, for at least one current signal (S₁) generated in step b), whether the current signal (S₁) comprises a pattern that indicates the occurrence of an arc-fault within the battery module.

3. The method of claim 1 or 2,
wherein at least one of the operations states measured in step a) is a voltage generated by the battery module (10) or an electrical potential difference inside the battery module (10);
wherein step b) comprises generating, as one of the operation signals, a voltage signal (S₂) based on at least one of the operations states measured in step a) being a voltage; and
wherein step c) comprises checking, for at least one voltage signal (S₂) generated in step b), whether the voltage signal (S₂) comprises a pattern that indicates the occurrence of an arc-fault within the battery module (10).

4. The method according to claim 2 or 3,
wherein step c) comprises the following sub-steps:
c-1) generating a frequency spectrum for at least one operation signal being a current signal and/or at least one voltage signal generated in step b); and
c-2) comparing at least one of the frequency spectra generated in step c-1) with a respective predefined reference frequency spectrum.

5. The method according to claim 4,
wherein step c-2) comprises detecting, whether at least for one frequency value comprised in the reference frequency spectrum, the amplitude of the frequency spectrum generated in step c-1) exceeds the amplitude of the reference frequency spectrum at this frequency value; and
wherein step d) comprises generating the warning signal upon detection, in step c-2), of at least one frequency value comprised in the reference frequency spectrum, at which the amplitude of the frequency spectrum generated in step c-1) exceeds the amplitude of the reference frequency spectrum.

6. The method according to claim 4 or 5, wherein step c-1) comprises performing a Fourier transform of at least a part of at least one current signal and/or at least one voltage signal generated in step b).

7. The method according to claim 6, wherein, for at least one operation signal being a current signal and/or a voltage signal, for which a Fourier transform is performed, the following sub-steps are performed:
- storing the amplitudes of the operation signal for a predefined number of sample points in time within a time window having a predefined duration;
- performing a fast Fourier transform based on the sample points and the stored amplitudes of the current.

8. The method according to claim 2 or 3,
wherein step c) comprises the following sub-steps:
c-i) inputting, for at least one of the operation signals generated in step a), the operation signal to at least one bandpass filter;
c-ii) measuring, for each bandpass filter, the amplitude of the signal outputted from the bandpass filter;
c-iii) comparing, for each signal outputted in step c-ii), its amplitude with a predefined reference value associated with this output signal; and
wherein step d) comprises generating the warning signal upon detecting, in step c-iii), an amplitude of at least one of the outputted signals, which exceeds the associated predefined reference value.

9. A method for disconnecting a battery module (10) from a load upon detection of a dielectric breakdown in a battery module (10), the method comprising the following steps:
- performing the method for detecting the occurrence of a dielectric breakdown in a battery module (10) according to any one of claims 1 to 8;
- disconnecting the battery module (10) from the load in response to the generation of a warning signal in step d) of the used method for detecting the occurrence of a dielectric breakdown in a battery module (10).

10. A battery system (1), comprising:
a battery module (10) comprising at least one battery cell;
a measurement means; and
a control unit (20);
wherein the measurement means is configured for performing the following steps of:
A) measuring at least one operation state of the battery module (10), and
B-1) generating, for each of the measured operation states, an operation signal corresponding to that measured operation state; and
wherein the control unit (20) is configured for performing the following steps of:
B-2) receiving the operation signals from the measurement means;
C) checking, for at least one of the received operation signals, whether the operation signal comprises a pattern that indicates the occurrence of an arc-fault within the battery module; and
D) generating a warning signal upon detection, in step C), of an operation signal comprising a pattern that indicates the possible occurrence of an arc-fault within the battery module.

11. The battery system according to claim 10,
wherein at least one of the operation states is a current generated by the battery module (10) or a current occurring in the battery module (10);
wherein the measurement means comprises a current sensor (41) configured for measuring said current;
wherein the current sensor (41) is configured for generating a current signal corresponding to the current measured by the current sensor (41), the current signal corresponding to one of the operation signals generated by the measurement means; and
wherein the control unit (20) is configured for checking, whether the current signal comprises a pattern that indicates the occurrence of an arc-fault within the battery module (10).

12. The battery system according to claim 10 or 11,
wherein at least one of the operation states is a voltage generated by the battery module (10) or an electrical potential difference inside the battery module (10);
wherein the measurement means comprises a voltage sensor (42) configured for measuring said voltage;
wherein the voltage sensor (42) is configured for generating a voltage signal corresponding to the voltage measured by the voltage sensor (42), the voltage signal corresponding to one of the operation signals generated by the measurement means; and
wherein the control unit (20) is configured for checking, whether the voltage signal comprises a pattern that indicates the occurrence of an arc-fault within the battery module (10).

13. The battery system according to claim 11 or 12, wherein the control unit (20) is configured for performing the following steps:
C-1) generating a frequency spectrum of at least one operation signal corresponding to a current signal or a voltage signal;
C-2) comparing at least one of the frequency spectra generated in step C-1) with a respective predefined reference frequency spectrum.

14. The battery system according to any one of claims 10 to 13, further comprising:
a first terminal connected, via a first electrical line to the at least one battery cell;
a second terminal connected, via a second electrical line to the at least one battery cell;
a first switch (50) configured for interrupt the first line upon receiving a first interruption signal; and
a second switch (50) configured for interrupting the second line upon receiving a second interruption signal; and
wherein the control unit (20) is configured for:
- sending, when generating a warning signal according to step D), a first interruption signal to the first switch (50); and/or
- sending, when generating a warning signal according to step D), a second interruption signal to the second switch (50).

15. A vehicle comprising at least one battery system according to any one of claims 10 to 14.

## Amended claims

### Amended claims in accordance with Rule 137(2) EPC.

1. A method for detecting the occurrence of a dielectric breakdown in a battery module (10), the method comprising the followings steps:
a) measuring at least one operation state being a current generated by the battery module (10), a current occurring in the battery module (10), a voltage generated by the battery module (10), or an electrical potential difference inside the battery module (10);
b) generating, for each of the operation states measured in step a), an operation signal being a current signal (Si) or a voltage signal (S₂) corresponding to that measured operation state;
c) checking, for at least one of the operation signals being a current signal (Si) or a voltage signal (S₂) generated in step b), whether the operation signal comprises a pattern that indicates the possible occurrence of an arc-fault within the battery module;
d) generating a warning signal upon detection, in step c), of an operation signal comprising a pattern that indicates the possible occurrence of an arc-fault within the battery module (10); wherein step c) comprises the following sub-steps:
c-1) generating a frequency spectrum for at least one operation signal being a current signal and/or at least one voltage signal generated in step b); and
c-2) comparing at least one of the frequency spectra generated in step c-1) with a respective predefined reference frequency spectrum; and
wherein step c-2) comprises detecting, whether at least for one frequency value comprised in the reference frequency spectrum, the amplitude of the frequency spectrum generated in step c-1) exceeds the amplitude of the reference frequency spectrum at this frequency value.

2. The method according to claim 1,
wherein step d) comprises generating the warning signal upon detection, in step c-2), of at least one frequency value comprised in the reference frequency spectrum, at which the amplitude of the frequency spectrum generated in step c-1) exceeds the amplitude of the reference frequency spectrum.

3. The method according to claim 1 or 2, wherein step c-1) comprises performing a Fourier transform of at least a part of at least one current signal and/or at least one voltage signal generated in step b).

4. The method according to claim 3, wherein, for at least one operation signal being a current signal and/or a voltage signal, for which a Fourier transform is performed, the following sub-steps are performed:
- storing the amplitudes of the operation signal for a predefined number of sample points in time within a time window having a predefined duration;
- performing a fast Fourier transform based on the sample points and the stored amplitudes of the current.

5. A method for disconnecting a battery module (10) from a load upon detection of a dielectric breakdown in a battery module (10), the method comprising the following steps:
- performing the method for detecting the occurrence of a dielectric breakdown in a battery module (10) according to any one of claims 1 to 4;
- disconnecting the battery module (10) from the load in response to the generation of a warning signal in step d) of the used method for detecting the occurrence of a dielectric breakdown in a battery module (10).

6. A battery system (1), comprising:
a battery module (10) comprising at least one battery cell;
a measurement means comprising a current sensor (41) and/or a voltage sensor (42); and
a control unit (20);
wherein the measurement means is configured for performing the following steps of:
A) measuring at least one operation state being a current generated by the battery module (10), a current occurring in the battery module (10), a voltage generated by the battery module (10), or an electrical potential difference inside the battery module (10), and
B-1) generating, by the current sensor (41), for each of the measured operation states being a current, an operation signal being a current signal (Si) corresponding to that measured operation state being a current, and/or generating, by the voltage sensor (42), for each of the measured operation states being a voltage, an operation signal being a voltage signal (S₂) corresponding to that measured operation state being a voltage; and
wherein the control unit (20) is configured for performing the following steps of:
B-2) receiving the operation signals from the measurement means;
C) checking, for at least one of the received operation signals being a current signal (Si) or a voltage signal (S₂), whether the operation signal comprises a pattern that indicates the occurrence of an arc-fault within the battery module; and
D) generating a warning signal upon detection, in step C), of an operation signal comprising a pattern that indicates the possible occurrence of an arc-fault within the battery module; and
wherein the control unit (20) is further configured for performing the following steps:
C-1) generating a frequency spectrum of at least one operation signal corresponding to a current signal or a voltage signal;
C-2) comparing at least one of the frequency spectra generated in step C-1) with a respective predefined reference frequency spectrum;
wherein step C-2) comprises detecting, whether at least for one frequency value comprised in the reference frequency spectrum, the amplitude of the frequency spectrum generated in step C-1) exceeds the amplitude of the reference frequency spectrum at this frequency value.

7. The battery system according to claim 6, further comprising:
a first terminal connected, via a first electrical line to the at least one battery cell;
a second terminal connected, via a second electrical line to the at least one battery cell;
a first switch (50) configured for interrupt the first line upon receiving a first interruption signal; and
a second switch (50) configured for interrupting the second line upon receiving a second interruption signal; and
wherein the control unit (20) is configured for:
- sending, when generating a warning signal according to step D), a first interruption signal to the first switch (50); and/or
- sending, when generating a warning signal according to step D), a second interruption signal to the second switch (50).

8. A vehicle comprising at least one battery system according to claim 6 or 7.
